(19) Europäisches Patentamt
European Patent Office
Office européen des brevets

(11) EP 1 737 276 A1

(12) EUROPEAN PATENT APPLICATION
published in accordance with Art. 158(3) EPC

(43) Date of publication:
**27.12.2006 Bulletin 2006/52**

(21) Application number: **05727875.6**

(22) Date of filing: **29.03.2005**

(51) Int Cl.:
***H05B 33/12*** *(2006.01)* ***H05B 33/14*** *(2006.01)*
***H05B 33/22*** *(2006.01)* ***H05B 33/24*** *(2006.01)*

(86) International application number:
**PCT/JP2005/005946**

(87) International publication number:
**WO 2005/104624 (03.11.2005 Gazette 2005/44)**

(84) Designated Contracting States:
**DE FR GB**

(30) Priority: **06.04.2004 JP 2004112005**

(71) Applicant: **IDEMITSU KOSAN CO., LTD.**
**Tokyo 100-8321 (JP)**

(72) Inventors:
- **KUMA, Hitoshi**
**2990293 (JP)**
- **ARAKANE, Takashi**
**2990293 (JP)**
- **EIDA, Mitsuru**
**2990293 (JP)**
- **HOSOKAWA, Chishio**
**2990293 (JP)**

(74) Representative: **Gille Hrabal Struck Neidlein Prop Roos**
**Brucknerstrasse 20**
**40593 Düsseldorf (DE)**

# (54) ORGANIC EL DISPLAY AND FULL COLOR DEVICE

(57) An organic EL display including: a first organic EL device including a first reflective electrode (2), a second reflective electrode (5) and an organic layer (4) provided therebetween, a second organic EL device including a first reflective electrode (2), a second reflective electrode (5), a light-transmitting layer (3) and an organic layer (4), the light-transmitting layer (3) and the organic layer (4) being provided between the first and second reflective electrodes (2) and (5), and a fluorescence conversion film (7G) and (7R) converting the color of light emitted from the second organic EL device. The angular distribution of the luminance intensity of light from the second organic EL device is smaller than the angular distribution of the luminance intensity of light from the first EL device by adjusting the optical film thicknesses L1 and L2 of the first and second organic EL devices.

FIG.1

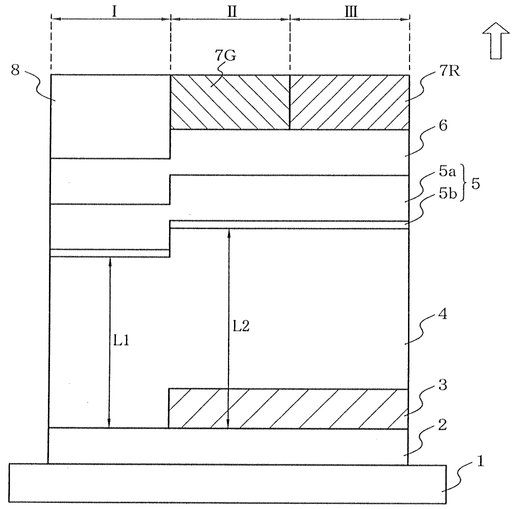




Printed by Jouve, 75001 PARIS (FR)

## Description

TECHNICAL FIELD

The invention relates to an organic electroluminescent (EL) display and a full color device.

BACKGROUND ART

An EL device generally has the properties of high visibility based on self-emission, excellent impact resistance based on a complete solid device and facility of handling, so that it attracts attention for its use as an emitting device in various displays. In particular, studies on organic EL devices for practical use have been intensively conducted, since its voltage to be applied can be remarkably reduced.
An organic EL display includes an organic EL device in which an emitting layer is placed between opposing electrodes. When applying voltage between the electrodes of the organic EL device, electrons injected from one electrode and holes injected from the other electrode recombine in the emitting layer. The organic luminescent molecules in the emitting layer are excited by the recombination energy, and then return to the ground state from the excited state. The organic EL device emits the released energy as light.
Attempts have been made to utilize optical interference for an organic EL device. For example, patent document 1 discloses a display device in which an emitting layer is provided between a first electrode formed of a reflective material and a second electrode formed of a transparent electrode and at least one of the emitting layer and the second electrode functions as a resonator of a resonator structure. This device is configured so that the optical length L of the resonator is a positive minimum value within the range satisfying the following expression.

$$(2L)/\lambda+\Phi/(2\pi) = m \text{ (m is an integer)}$$

L: optical length of the resonator
Φ: phase shift which occurs when light from the emitting layer is reflected between the opposite sides of the resonator
λ: peak wavelength of the spectrum of light from the emitting layer to be outcoupled

Patent document 2 discloses an organic EL device utilizing the above interference effect. This device includes a pair of reflective electrodes positioned on either side of an organic layer, and a film which is provided outside the reflective electrode through which light from the organic layer is outcoupled and converts the color of light from the organic layer through fluorescence conversion. In this device, the optical thickness between the reflective interfaces defined by the pair of reflective electrodes is set so that the intensity of light from the organic layer with a specific wavelength is enhanced, and the fluorescence conversion film has a function of absorbing the light with the specific wavelength and making the light isotropic by eliminating its anisotropy.
However, when forming a top emission type display by utilizing the technology disclosed in the patent document 2, a large portion of light from the emitting layer is completely reflected at the interface between the solid sealing layer and the fluorescence conversion film, whereby the luminous efficiency decreases. This phenomenon occurs because $SiO_xN_{1-x}$, which is generally used as the material for the solid sealing layer, has a refractive index of about 2.0 to 2.2, and the fluorescence conversion film has a refractive index of 1.5 to 1.7.
A decrease in the luminous efficiency can be solved by utilizing a higher-order interference effect. This is because the angular distribution of the intensity of light becomes narrower as the order of interference becomes higher, whereby the intensity of light absorbed by the fluorescence conversion film is increased. On the other hand, since a pixel which is not provided with the fluorescence conversion film does not have the function of making light isotropic, the viewing angle becomes significantly narrower as the order of interference becomes higher.
[Patent document 1] WO/0139554
[Patent document 2] JP-A-9-92466
An object of the invention is to provide an organic EL display and full color device exhibiting a high luminous efficiency and excellent viewing angle characteristics.

DISCLOSURE OF THE INVENTION

As a result of extensive studies, the inventers found that a luminous efficiency and viewing angle characteristics can be improved by differing an optical thickness between reflective electrodes and an angular distribution of a luminance intensity of light emitted from an organic EL device between a pixel including a fluorescence conversion film and a pixel

including no fluorescence conversion films. This finding has led to the completion of the invention.
According to the invention, an organic EL display and full color device shown below are provided.

1. An organic electroluminescent display comprising:

a first organic electroluminescent device comprising a first reflective electrode, a second reflective electrode and an organic layer provided therebetween,
a second organic electroluminescent device comprising a first reflective electrode, a second reflective electrode, a light-transmitting layer and an organic layer, the light-transmitting layer and the organic layer being provided between the first and second reflective electrodes, and
a fluorescence conversion film converting the color of light emitted from the second organic electroluminescent device;
the angular distribution of the luminance intensity of light from the second organic electroluminescent device being smaller than the angular distribution of the luminance intensity of light from the first electroluminescent device.

2. An organic electroluminescent display comprising:

a first organic electroluminescent device comprising a first reflective electrode, a second reflective electrode, a first light-transmitting layer and an organic layer, the first light-transmitting layer and the organic layer being provided between the first and second reflective electrodes,
a second organic electroluminescent device comprising a first reflective electrode, a second reflective electrode, a second light-transmitting layer and an organic layer, the second light-transmitting layer and the organic layer being provided between the first and second reflective electrodes, and
a fluorescence conversion film converting the color of light emitted from the second organic electroluminescent device;
the angular distribution of the luminance intensity of light from the second organic electroluminescent device being smaller than the angular distribution of the luminance intensity of light from the first electroluminescent device.

3. An organic electroluminescent display comprising:

a first organic electroluminescent device comprising a first reflective electrode, a second reflective electrode and an organic layer provided therebetween,
a second organic electroluminescent device comprising a first reflective electrode, a second reflective electrode, a first light-transmitting layer and an organic layer, the first light-transmitting layer and the organic layer being provided between the first and second reflective electrodes,
a third organic electroluminescent device comprising a first reflective electrode, a second reflective electrode, a second light-transmitting layer and an organic layer, the second light-transmitting layer and the organic layer being provided between the first and second reflective electrodes,
a first fluorescence conversion film converting the color of light emitted from the second organic electroluminescent device, and
a second fluorescence conversion film converting the color of light emitted from the third organic electroluminescent device;
the angular distribution of the luminance intensity of light from the second organic electroluminescent device being smaller than the angular distribution of the luminance intensity of light from the first electroluminescent device, and
the angular distribution of the luminance intensity of light from the third organic electroluminescent device being smaller than the angular distribution of the luminance intensity of light from the first electroluminescent device.

4. The organic electroluminescent display according to 2 or 3 wherein the second light-transmitting layer comprises the first light-transmitting layer in part.
5. The organic electroluminescent display according to any one of 1 to 4 further comprising a solid sealing layer sealing an organic electroluminescent device.
6. The organic electroluminescent display according to 5 wherein the solid sealing layer is provided between the second reflective layer and the fluorescence conversion film.
7. The organic electroluminescent display according to any one of 1 to 6 wherein at least one of the first and second light-transmitting layers is a transparent conductive layer or transparent semiconductive layer.

8. The organic electroluminescent display according to any one of 1 to 7 wherein one reflective electrode through which light is outcoupled of the first and second reflective electrodes has a reflectance of 25 or more and less than 50%, and the other reflective electrode has a reflectance of 50% or more.
9. The organic electroluminescent display according to any one of 1 to 8 wherein at least one of the first and second light-transmitting layers is stacked layers of a dielectric and a transparent electrode.
10. The organic electroluminescent display according to any one of 1 to 8 wherein at least one of the first and second light-transmitting layers is stacked layers of a metal film and a transparent electrode.
11. The organic electroluminescent display according to any one of 1 to 8 wherein at least one of the first and second light-transmitting layers comprises a dielectric multilayered film.
12. The organic electroluminescent display according to 3 wherein the first fluorescence conversion film and the second fluorescence conversion film convert light emitted from the organic layers into light of different colors.
13. The organic electroluminescent display according to 12 wherein one of the maximum values of an emission spectrum of light from the first organic electroluminescent device is in a blue region,

at least one of the maximum values of an emission spectrum of light from the first fluorescence conversion film which is converted light of the second organic electroluminescent device is in a green region, and
at least one of the maximum values of an emission spectrum of light from the second fluorescence conversion film which is converted light of the third organic electroluminescent device is in a red region.

In the invention, the angular distribution of the luminance intensity of light from the organic EL device is changed for a pixel including the fluorescence conversion film and a pixel which does not include the fluorescence conversion film by separately adjusting the optical thickness between the reflective electrodes. Specifically, the angular distribution is made narrow in the pixel including the fluorescence conversion film so that light is concentrated at an optimum wavelength for the fluorescence conversion film, thereby increasing the luminous efficiency. In the pixel including the fluorescence conversion film, the fluorescence conversion film makes the absorbed light isotropic by eliminating its anisotropy, thereby increasing the viewing angle characteristics. In the pixel which does not include the fluorescence conversion film, the angular distribution need not be made narrow in comparison with the pixel including the fluorescence conversion film, and the fluorescence conversion film which makes light with a narrow angular distribution isotropic is not provided. Therefore, the angular distribution is made wider than that of the pixel including the fluorescence conversion film. This also improves the viewing angle characteristics of the pixel which does not include the fluorescence conversion film.
According to the invention, an organic EL display and a full color device exhibiting high luminous efficiency and excellent viewing angle characteristics are obtained.

## BRIEF DESCRIPTION OF THE DRAWINGS

FIG. 1 is a view showing one embodiment of an organic EL display according to the invention.
FIG. 2 is a view showing another embodiment of the organic EL display according to the invention.
FIG. 3 is a view showing still another embodiment of the organic EL display according to the invention.
FIG. 4 is a view showing yet another embodiment of the organic EL display according to the invention.

## BEST MODE FOR CARRYING OUT THE INVENTION

### First embodiment

FIG. 1 is a view showing one embodiment of an organic EL display according to the invention. A first reflective electrode 2, a light-transmitting layer 3, an organic layer 4, a second reflective electrode 5, and a solid sealing layer 6 are stacked in that order on one surface of a substrate 1. A transparent layer 8, a green fluorescence conversion film 7G, and a red fluorescence conversion film 7R are provided on the solid sealing layer 6. The reflective electrode 5 includes a metal film 5b and a transparent electrode 5a. One of the reflective electrodes 2 and 5 serves as an anode, and the other serves as a cathode. The arrow indicates the light-outcoupling direction.
The first reflective electrode 2, the organic layer 4, the second reflective electrode 5, and the solid sealing layer 6 form a first organic EL device, and the first reflective electrode 2, the light-transmitting layer 3, the organic layer 4, the second reflective electrode 5, and the solid sealing layer 6 form a second organic EL device. L1 schematically indicates the optical thickness between the reflective electrodes 2 and 5 of the first organic EL device, and L2 schematically indicates the optical thickness between the reflective electrodes 2 and 5 of the second organic EL device. The optical

thickness is the product of the actual thickness and the refractive index, as described later.

The first organic EL device and the transparent layer 8 form a blue pixel I, the second organic EL device and the green fluorescence conversion film 7G form a green pixel II, and the second organic EL device and the red fluorescence conversion film 7R form a red pixel III.

The organic layer 4 emits blue light.
In the blue pixel I, the blue light which has passed through the second reflective electrode 5 passes through the transparent layer 8 and is emitted to the outside.
In the green pixel II, the blue light which has passed through the second reflective electrode 5 is converted into green light by the green fluorescence conversion film 7G and emitted to the outside.
In the red pixel III, the blue light which has passed through the second reflective electrode 5 is converted into red light by the red fluorescence conversion film 7R and emitted to the outside.
A full color device is realized by using these pixels.
It is preferable that the maximum value of the emission spectrum of the blue light be 420 to 500, the maximum value of the emission spectrum of the green light be 500 to 550, and the maximum value of the emission spectrum of the red light be 550 to 650.

In the green pixel II and the red pixel III, since the optical thickness L2 of the second organic EL device is adjusted as described later, light from the organic layer 4 is repeatedly reflected between the opposing reflective electrodes 2 and 5 so that the optimum wavelengths for the fluorescence conversion films 7G and 7R are enhanced through multiple interference, whereby the light is emitted through the reflective electrode 5 with a narrow angular distribution. This increases the intensity of light absorbed by the fluorescence conversion film, whereby the fluorescence conversion films 7G and 7R exhibit high luminous efficiency. The fluorescence conversion films 7G and 7R also have a function of absorbing light from the organic layer 4 and making the light isotropic by eliminating its anisotropy. Therefore, light from the second organic EL device with a narrow angular distribution is made isotropic by the fluorescence conversion films 7G and 7R and then emitted to the outside. As a result, the viewing angle is increased to a large extent. In the blue pixel I, since the optical thickness L1 of the first organic EL device is adjusted as described later, light from the organic layer 4 is repeatedly reflected between the opposing reflective electrodes 2 and 5 so that the blue wavelength is enhanced through multiple interference in the same manner as in the green pixel II and red pixel III, and is emitted through the reflective electrode 5. Since the optical thickness L1 is adjusted as described later with respect to the optical thickness L2, the angular distribution of light from the first organic EL device is broader than the angular distribution of light from the second organic EL device. Therefore, a wide viewing angle is ensured for the blue pixel I without providing a fluorescence conversion film.

In this embodiment, the angular distribution of luminance intensity is defined as follows. The luminance measured for an emitting surface sufficiently greater than the photometric area using a luminance meter in the direction normal to the emitting surface is referred to as $L_0$. When the luminance measured in the direction at an angle $\theta$ with respect to the normal direction is referred to as $L(\theta)$, the angular distribution of luminance intensity is indicated by $L(\theta)\cdot\cos\theta/L_0$.

In order to allow the angular distribution of the light intensity from the second organic EL device to be narrower than the angular distribution of the light intensity from the first organic EL device, the optical thickness L between the reflective interfaces defined by the pair of reflective electrodes 2 and 5 is adjusted within the range satisfying the following expression (1) so that m of the green pixel II and the red pixel III respectively provided with the fluorescence conversion film becomes greater than m of the blue pixel I which is not provided with a fluorescence conversion film.

$$(2L)/\lambda+\Phi/(2\pi) = m \text{ (m is an integer)} \quad (1)$$

L: optical thickness between the reflective interfaces
$\Phi$: phase shift which occurs when light from the organic layer is reflected at the reflective electrode interfaces $\lambda$: peak wavelength of the spectrum of light from the organic layer to be outcoupled

The optical thickness L is preferably adjusted so that m is an integer from 1 to 10, more preferably adjusted so that m is an integer from 1 to 5, and still more preferably adjusted so that m of the green pixel II and the red pixel III is 2 and m of the blue pixel I is 1.

A method of calculating the optical thickness L between the reflective interfaces is given below. A thin film of the material for the member (organic layer 4) provided between the reflective electrodes 2 and 5 is formed on a supporting substrate. The resulting thin film sample is subjected to optical measurement using an ellipsometer or the like to determine the refractive index n of the material. The product of the thickness d and the refractive index n of each layer when forming the organic EL device is calculated, and the optical length L is determined by calculating the sum of the products. For example, when the refractive index and the thickness of each layer forming the organic layer 4 are respectively indicated

by n1, n2, ..., and nk and d1, d2, ..., and dk, the optical thickness L is calculated using the following expression (2).

$$L = n1 \times d1 + n2 \times d2 + ... + nk \times dk \quad (2)$$

The phase shift Φ is indicated by the following expression (3).

$$\Phi = \Phi_1 + \Phi_2 \quad (3)$$

The phase shift Φ1 is calculated as follows. A desired reflective electrode 2 is formed on a supporting substrate. The resulting thin film sample is subjected to optical measurement using an ellipsometer or the like to determine the refractive index no and the extinction coefficient $k_0$ of the material. The amplitude reflectance r of the reflective electrode may be calculated using the following expression (4). Note that $n_1$ indicates the refractive index of the material for the layer in contact with the reflective electrode 2 on the side of the reflective electrode 5, and i indicates an imaginary unit.

$$r = \frac{n_1 - (n_0 - i\kappa_0)}{n_1 + (n_0 - i\kappa_0)} \quad (4)$$

The amplitude reflectance r is a complex number, and may be indicated as r=a+i·b. In this case, the phase shift Φ1 may be calculated using the following expression (5).

$$\Phi_1 = \arctan\left(\frac{2n_1\kappa_0}{n_1^2 - n_0^2 - \kappa_0^2}\right) \quad (5)$$

The phase shift $\Phi_2$ may be calculated by calculating the refractive index and the extinction coefficient of the reflective electrode 5 and the refractive index of the material for the layer in contact with the reflective electrode 5 on the side of the reflective electrode 2 and substituting the resulting values into the expression (5).

The reflective electrodes 2 and 5 are conductive films having a function of reflecting light from the organic layer 4, and generally have a reflectance of 10% or more. It is preferable from the viewpoint of the effects of the invention that one of the reflective electrodes 2 and 5 have a reflectance of 50% or more, and particularly preferably 70% or more, and the other reflective electrode have a reflectance of 25% or more. It is preferable from the viewpoint of the effects of the invention that one of the reflective electrodes 2 and 5 having a reflectance of 50% or more have a thickness of 100 to 300 nm, and the other reflective electrode have a thickness of 5 to 50 nm.

In this embodiment, in order to allow light from the organic layer 4 to pass through the second reflective electrode 5, it is preferable that the reflectance of the second reflective electrode 5 be lower than the reflectance of the first reflective electrode 2.

The reflectance of the reflective electrode according to the invention means the value measured using the following method. A mirror (e.g. magnesium fluoride/aluminum stacked mirror) with a known reflectance is provided. The reflectance of the mirror is referred to as $R_0$. The reflection intensity of the mirror is measured using a reflection microspectrometer utilizing a light source such as a tungsten lamp. The resulting reflection intensity of the mirror is referred to as $I_0$. Likewise, the reflection intensity of the reflective electrode is measured. The resulting reflection intensity is referred to as $I_{el}$. The reflectance R of the reflective electrode is calculated using the following expression (6).

$$R = R_0 \times (I_{el} / I_0) \quad (6)$$

In order to increase the intensity of light from the pixels II and III respectively provided with the fluorescence

conversion film, it is preferable to increase the thickness of only the reflective electrode 2 distant from the fluorescence conversion films 7G and 7R.

When applying a direct-current voltage to the organic EL device according to this embodiment, light with a high chromatic purity can be observed by applying a voltage of about 5 to about 40 V using the anode as a positive electrode and the cathode as a negative electrode. A current does not flow when applying a voltage in a state in which the polarities are reversed, whereby emission of light does not occur. When applying an alternating-current voltage, light is emitted only when the anode is used as a positive electrode and the cathode is used as a negative electrode. Note that the alternating-current waveform to be applied may be arbitrary.

In this embodiment, the first organic EL device does not include an optical thickness adjustment layer. Note that the optical thickness of the first organic EL device may be adjusted by providing an optical thickness adjustment layer. The optical thickness adjustment layers included in the first and second organic EL devices may be formed of either a single layer or a plurality of layers.

The pixels I, II, and III may be respectively provided with blue, green, and red color filters.

## Second embodiment

FIG. 2 is a view showing another embodiment of the organic EL display according to the invention.

As shown in FIG. 2, this organic EL display differs from the organic EL display according to the first embodiment in that a second light-transmitting layer differing from the first light-transmitting layer is provided in the red pixel III.

In this embodiment, the first reflective electrode 2, the organic layer 4, the second reflective electrode 5, and the solid sealing layer 6 form a first organic EL device.

The first reflective electrode 2, the first light-transmitting layer 3, the organic layer 4, the second reflective electrode 5, and the solid sealing layer 6 form a second organic EL device.

The first reflective electrode 2, a second light-transmitting layer 9, the organic layer 4, the second reflective electrode 5, and the solid sealing layer 6 form a third organic EL device. In the second light-transmitting layer 9, another light-transmitting layer is further provided on the first light-transmitting layer 3. This light-transmitting layer may be formed of a material the same as or different from the material for the first light-transmitting layer.

L1 schematically indicates the optical thickness between the reflective electrodes 2 and 5 of the first organic EL device, L2 schematically indicates the optical thickness between the reflective electrodes 2 and 5 of the second organic EL device, and L3 schematically indicates the optical thickness between the reflective electrodes 2 and 5 of the second organic EL device.

The first organic EL device and the transparent layer 8 form a blue pixel I, the second organic EL device and the green fluorescence conversion film 7G form a green pixel II, and the third organic EL device and the red fluorescence conversion film 7R form a red pixel III.

The optical thicknesses L1, L2, and L3 are adjusted as described above by adjusting the thickness of the light-transmitting layer, whereby light of which the wavelength optimum for the fluorescence conversion film 7G is enhanced is emitted from the second organic EL device with an angular distribution narrower than that of the first organic EL device, and light of which the wavelength optimum for the fluorescence conversion film 7R is enhanced is emitted from the third organic EL device with an angular distribution narrower than that of the first organic EL device. This increases the intensity of light absorbed by the fluorescence conversion film, whereby the fluorescence conversion films 7G and 7R exhibit high luminous efficiency. Moreover like the first embodiment, light from the second and third organic EL devices with a narrow angular distribution is made isotropic by the fluorescence conversion films 7G and 7R and then emitted to the outside.

## Third embodiment

FIG. 3 is a view showing still another embodiment of the organic EL display according to the invention.

In the organic EL display according to this embodiment, the fluorescence conversion films 7G and 7R and the transparent layer 8, the second reflective electrode 5, the light-transmitting layer 3, the organic layer 4, the first reflective electrode 2, and the solid sealing layer 6 are stacked in that order on a single surface of the substrate 1, as shown in FIG. 3. This organic EL display differs from the organic EL display according to the first embodiment as to the positions of the fluorescence conversion films 7G and 7R and the transparent layer 8 and the light-outcoupling direction.

Specifically, light from the organic layer 4 is emitted to the outside through the substrate 1 after passing through the transparent layer 8 or after being converted by the fluorescence conversion films 7G and 7R. In the green pixel II and the red pixel III, light from the organic layer 4 is allowed to have a narrow angular distribution by adjusting the optical thicknesses L1 and L2 and is made isotropic using the fluorescence conversion films 7G and 7R in the same manner as in the first embodiment.

Note that the reflectance of the first reflective electrode 2 is increased in this embodiment.

Fourth embodiment

FIG. 4 is a view showing yet another embodiment of the organic EL display according to the invention. In the organic EL display according to this embodiment, the fluorescence conversion films 7G and 7R and the transparent layer 8, the substrate 1, the second reflective electrode 5, the organic layer 4, the light-transmitting layer 3, the first reflective electrode 2, and the solid sealing layer 6 are stacked in that order, as shown in FIG. 4.

The first reflective electrode 2, the organic layer 4, the second reflective electrode 5, and the solid sealing layer 6 form a first organic EL device, and the first reflective electrode 2, the light-transmitting layer 3, the organic layer 4, the second reflective electrode 5, and the solid sealing layer 6 form a second organic EL device.

In this organic EL display, light from the organic layer 4 passes through the substrate 1 and is emitted to the outside through the transparent layer 8 or after being converted by the fluorescence conversion films 7G and 7R. In the green pixel II and the red pixel III, light from the organic layer 4 is allowed to have a narrow angular distribution by adjusting the optical thicknesses L1 and L2 and is made isotropic using the fluorescence conversion films 7G and 7R in the same manner as in the first embodiment.
Note that the reflectance of the first reflective electrode 2 is increased in this embodiment.

In the first to fourth embodiments, another layer may be provided between the members insofar as the object of the invention is not impaired. In the first to third embodiments, a light-transmitting layer may be arbitrarily provided between the fluorescence conversion films 7G and 7R and the reflective electrode 5, for example. As the light-transmitting layer, a layer formed of glass, an oxide, a transparent polymer, or the like can be given.

In the first to fourth embodiments, the light-transmitting layers 3 and 9 may be formed at arbitrary positions between the first and second reflective electrodes 2 and 5. The light-transmitting layers 3 and 9 are usually formed to contact the organic layer 4 in order to facilitate production.

Each member used in the above embodiments is described below. As the material for each member, a known material other than the materials given below may also be used insofar as the requirements according to the invention are satisfied.

1. Reflective electrode

As examples of the reflective electrode, the following electrodes (1) to (4) can be given.

(1) Metal electrode
An electrode formed of a metal which reflects light, such as Au, Ag, Al, Pt, Cu, W, Cr, Mn, Mg, Ca, Li, Yb, Eu, Sr, Ba, or Na, or an alloy of two or more metals arbitrarily selected from these metals, such as Mg:Ag, Al:Li, Al:Ca, or Mg:Li, can be given. Of these, a metal or alloy having a work function of 4.0 eV or less is preferable as the cathode, and a metal or alloy having a work function of 4.5 eV or more is preferable as the anode.

(2) Stacked reflective electrode of metal film/transparent electrode or transparent electrode/metal film
Since a transparent electrode itself has a low reflectance, the reflectance can be increased by stacking the transparent electrode and a metal film. As the material for the transparent electrode, a conductive oxide is preferable. In particular, ZnO:Al, indium tin oxide (ITO), $SnO_2$:Sb, InZnO, and the like are preferable. As the metal film, a film made of the metal or alloy described in (1) is preferably used. In the stacked reflective electrode, either the transparent electrode or the metal film may be arranged in the side contacting the organic layer.

(3) Stacked reflective electrode of dielectric film /transparent electrode or transparent electrode/dielectric film
Since a transparent electrode itself has a low reflectance as described above, the reflectance can be increased by stacking the transparent electrode and a high-refractive-index or low-refractive-index dielectric film. As the high-refractive-index dielectric film, a transparent oxide film or a transparent nitride film having a refractive index of 1.9 or more is preferable. A transparent sulfide film or selenide compound film is also preferable.

As examples of the high-refractive-index dielectric film, films formed of ZnO, $ZrO_2$, $HfO_2$, $TiO_2$, $Si_3N_4$, BN, GaN, GaInN, AlN, $Al_2O_3$, ZnS, ZnSe, ZnSSe, and the like can be given. A film formed by dispersing a powder of such a compound in a polymer may also be used.

As examples of the low-refractive-index dielectric film, a transparent oxide film or a transparent fluoride film having a refractive index of 1.5 or less, a film formed by dispersing a powder of such an oxide or fluoride in a polymer,

a fluoropolymer film, and the like can be preferably given. Specifically preferred are a film formed of $MgF_2$, $CaF_2$, $BaF_2$, NaAlF, SiOF, or the like, a film formed by dispersing a powder of such a compound in a polymer, and a film formed of a fluorinated polyolefin, fluorinated polymethacrylate, and fluorinated polyimide.

(4) Stacked reflective electrode of dielectric multilayer film/transparent electrode or dielectric multilayer film/metal electrode

The dielectric multilayer film in this stacked reflective electrode is a film formed by alternately stacking the high-refractive-index dielectric film and the low-refractive-index dielectric film described in (3) a number of times. As the transparent electrode, the transparent electrode described in (2) can be given. As the metal film, the metal film described in (1) can be given.

In the invention, it is particularly preferable that one of the pair of reflective electrodes include a multilayered structure of the high-refractive-index dielectric and the transparent electrode, or the dielectric multilayer film. The reflective electrode may be formed by using a deposition method or a sputtering method, for example. As examples of the deposition method, a resistance heating method, an electron beam method, and the like can be given. As examples of the sputtering method, a DC sputtering method, an ion beam sputtering method, an electron cyclotron resonance (ECR) method, and the like can be given.

2. Substrate

When the substrate is provided in the light emission path, a substrate having optical transparency is used. As examples of such a substrate, substrates formed of glass, quartz, an organic polymer compound, and the like can be given. Of these, a substrate having a refractive index of 1.6 or less is preferable.

3. Light-transmitting layer

In the invention, the light-transmitting layer is a layer which adjusts the optical thickness between a pair of reflective electrodes and is made of a substance transparent to visible light (having a transmittance of 50% or more in the visible light region).

The material used for the light-transmitting layer is not particularly limited insofar as the material is transparent. A transparent conductive material, transparent semiconductive material and transparent organic material are preferable.

As the transparent conductive material or transparent semiconductive material, conductive oxides are preferable. As specific examples of the conductive oxide, ITO (tin-doped indium oxide), IZO (zinc-doped indium oxide), ZnO, ZnO:Al, $SnO_2$, $SnO_2$:Sb, $In_2O_3$, NbO, LaO, NdO, SmO, $EuO_x$, $MoO_3$, $MoO_2$, $ReO_2$, $ReO_3$, $OSO_2$, $IrO_2$, $PtO_2$, $LiTi_2O_4$, $LiV_2O_4$, $Er_xNbO_3$, $LaTiO_3$, $SrVO_3$, $CaCrO_3$, $Sr_xCrO_3$, $A_xMoO_3$, $AV_2O_5$ (A = K, Cs, Rb, Sr, Na, Li or Ca) and the like can be given.

As the transparent organic material, a material used for the organic layer described later, conductive organic radical salt, conductive polymer, and the like can be given. As an example of the conductive organic radical salt, there is given a salt which is a combination of a donor such as TTF (tetrathiafluvalene), TTT (tetrathiotetracene), TPBP (tetraphenylbipyranylidene), HMTTeF (hexamethylenetetratellurafulvalene), TMTSF (tetramethyltetraselenafuluvalene), TMTTF (tetramethyltetrathiafulvalene), BEDT-TTF (bis(ethylenedithio)tetrathiafulvalene), BEDO-TTF (bis(ethylenedioxo) tetrathiafulvalene), DMET (dimethyl(ethylenedithio)diselenadithiafulvalene), and ETP (ethylenedithiopropylenedithiotetrathiafulvalene); and an accepter such as an organic material such as TCNQ (tetracyanoquinodimethane), TCNQ-4F (fluorinated tetracyanoquinodimethane), TCNDQ (tetracyanodiphenoquinodimethane), TCNTQ (tetracyanotriphenoquinodimethane), TNAP (tetracyano2,6-naphtoquinodimethane), TANT (11,11,12,12-tetracyano2,6-anthraquinodimethane), DCNQI (dicyanoquinonediimine), OCNAQ represented by the following formula (1), $M(dmit)_2$ (M = Ni, Nd, Zn, Pt) represented by the following formula (2); and $TaF'_6$, $AsF_6$, $PF_6$, $ReO_4$ $C10_4$, $BF_4$, Au,$(CN)_2$, $Ni(CN)_4$, $CoCl_4$, CoBr, $I_3$, $I_2Br$, $IBr_2$, $AuI_2$, $AuBr_2$, $Cu_5I_6$, $CuCl_4$, $Cu(NCS)_2$, $FeCl_4$, $FeBr_4$, $MnCl_4$, $KHg(SCN)_4$, $Hg(SCN_3)$, $NH_4(SCN)_4$. As the donor which is combined with the accepter of the organic material, Li, K, Na, Rb, Ca, Cs, La, $NH_4$ and the like can be used.

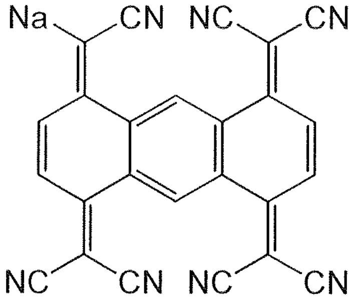

(1)

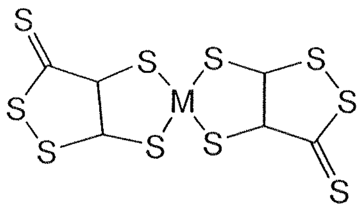

(2)

As the conductive polymer, polyacetylene, polyazulene, polyphenylene, polyphenylenevinylene, polyacene, polyphenyleneacetylene, polydiacetylene, polypyrrole, polyaniline, polythiophene, polythienylenevinylene and the like can be given. Materials with a light transmittance used for the solid sealing layer described later can also be used. These materials may be used either individually or in a mixture, or layers formed of them may be stacked.

4. Organic layer

As the organic layer arranged between a pair of reflective electrodes, the following configurations can be given as examples of the configuration from a reflective electrode as the anode to a reflective electrode as the cathode.

(1) Hole injecting layer/emitting layer
(2) Hole transporting layer/emitting layer
(3) Emitting layer/electron injecting layer
(4) Hole injecting layer/emitting layer/electron injecting layer
(5) Hole transporting layer/emitting layer/electron injecting layer
(6) Hole injecting layer/hole transporting layer/emitting layer/electron injecting layer
(7) Hole injecting layer/emitting layer/hole blocking layer/electron injecting layer
(8) Hole injecting layer/emitting layer/electron injecting layer/adhesion improving layer
(9) Hole transporting layer/emitting layer/adhesion improving layer
(10) Hole injecting layer/electron barrier layer/emitting layer/electron injecting layer

Of these configurations, the "hole transporting layer/emitting layer" configuration, the "hole transporting layer/emitting layer/electron injecting layer" configuration, and the "hole transporting layer/emitting layer/adhesion improving layer" configuration are preferable. The organic layer may include an inorganic compound layer, if necessary.

Like a general emitting layer, the emitting layer of the organic layer has the following functions: (a) an injection function; which enables to inject holes from an anode or hole-injecting layer and to inject electrons from a cathode or electron-injecting layer, when an electric field is impressed, (b) a transport function; which transports electrons and holes with an electric field's power, and (c) an emitting function; which provides a recombination site for electrons and holes to emit light. The thickness of the emitting layer is appropriately selected in such a range that the thickness satisfies m of the formula (1). The thickness is preferably 1 nm to 10 $\mu$m and more preferably 5 nm to 5 $\mu$m.

The emitting layer described above can be formed by a known method such as vapor deposition, spin coating, casting or LB technique. In particular, the emitting layer is preferably a molecule-deposited film. The molecule-deposited film is a thin film formed by precipitation and deposition from a compound for the emitting layer in a gas phase state or a film formed by solidification from the compound in a molten state or a liquid phase state. This molecule-deposited film can be usually distinguished from the thin film formed by LB technique (the molecule-accumulated film) by difference in aggregation structure or high-order structure, or by functional difference resulting therefrom. The emitting layer can be formed by dissolving a compound for the emitting layer together with a binder such as resins into a solvent to prepare

a solution and then making this into a thin film by spin coating or the like.

Next, the hole transporting layer is not essential, but it is preferably used to improve a luminous performance. Such a hole transporting layer is preferably made of a material which can transport holes to the emitting layer at a lower electric field intensity. The hole mobility thereof is preferably at least $10^{-6}$ $cm^2/V \cdot second$ when an electric field of, e.g., $10^4$ to $10^6$ V/cm is applied. The material for forming the hole transporting layer is not particularly limited so long as the material has the above-mentioned preferred natures. The material can be arbitrarily selected from materials which have been widely used as a hole transporting material in photoconductive materials and known materials used in a hole transporting layer of organic EL devices.

The hole transporting layer can be formed by making the hole-transporting material into a thin film by a known method such as vacuum deposition, spin coating, casting or LB technique.

The thickness of the hole transporting layer is not particularly limited, and is usually from 5 nm to 5 μm. This hole transporting layer may be a single layer made of one type or two or more types of hole-transporting materials. The hole transporting layer may also be stacked hole transporting layers made of different materials.

Between the emitting layer and the reflective electrode of the anode, an electron barrier layer may be formed to keep electrons in the emitting layer.

The electron injecting layer, which is made of an electron injecting material, has a function for transporting electrons injected from the cathode to the emitting layer. The electron injecting material is not particularly limited. The material can be arbitrarily selected from compounds which have been widely known.

The electron injecting layer can be formed by making the electron injecting material into a thin film by a known method such as vacuum deposition, spin coating, casting or LB technique.

The thickness of the electron injecting layer is usually from 5 nm to 5 μm. This electron injecting layer may be a single layer made of one type or two or more types of electron-injecting materials. Alternatively, it may be constituted by stacking plural electron injecting layers each made of a material different from each other.

The adhesion improving layer preferably comprises a material good in electron-transmittance, and adhesion to an emitting layer and the cathode. Specific examples of such materials include metal complexes of 8-hydroxyquinoline or derivatives such as metal chelate oxynoid compounds containing a chelate of oxine (generally, 8-quinolinol or 8-hydroxyquinoline). Specifically, examples thereof include tris(8-quinolinol)aluminum, tris(5,7-dichloro-8-quinolinol)aluminum, tris(5,7-dibromo-8-quinolinol)aluminum and tris(2-methyl-8-quinolinol)aluminum, and complexes thereof with indium, magnesium, copper, gallium, tin and lead instead of aluminum.

5. Solid sealing layer

As the material for the solid sealing layer, silicon oxide ($SiO_2$), silicon nitride (SiN) and the like can be used. For example, the layer may be formed in a thickness of 500 to 10000 nm.

6. Fluorescence conversion film

The fluorescence conversion film is arranged outside the light-outcoupling side reflective electrode in order to change the color of light emitted from the organic layer and having a center wavelength of λ. The color conversion film is formed of a fluorescent material.

As the material for the fluorescence conversion film, an inorganic fluorescent material and an organic fluorescent material can be given. In particular, a material prepared by dispersing an organic fluorescent substance in a polymer is preferable. As the organic fluorescent substance, coumarins, rhodamines, fluoresceines, cyanines, porphyrins, naphthalimides, perylenes, quinacridons, and the like are preferable due to their high fluorescence quantum yield. A substance having a fluorescence quantum yield of 0.3 or more in a state where the substance is dispersed in a polymer binder is particularly preferable. The organic fluorescent substance may be used either individually or in combination of two or more. As the polymer binder, a transparent resin such as polymethacrylate, polycarbonate, polyvinyl chloride, polyimide, polyamic acid, polyolefin, or polystyrene is preferably used.

The fluorescence conversion film has a function of absorbing light emitted from the organic layer and having a center wavelength of λ to cause the light to be isotropic by eliminating the anisotropy thereof. The fluorescence conversion film may be formed by using various methods without specific limitations. For example, the fluorescence conversion film is obtained by dispersing an organic fluorescent substance in a polymer binder and forming the mixture into a film having a thickness of 500 to 50000 nm, and preferably 1000 to 5000 nm using a method such as a casting method, a spin coating method, a printing method, a bar coating method, an extrusion forming method, a roll forming method, a pressing method, a spraying method, or a roll coating method. When using an organic solvent in the above film formation methods, dichloromethane, 1,2-dichloroethane, chloroform, acetone, cyclohexanone, toluene, benzene, xylene, N,N-dimethylformamide, dimethylsulfoxide, 1,2-dimethoxyethane, diethylene glycol dimethyl ether, and the like may be used as the organic solvent. These solvents may be used either individually or in combination of two or more.

7. Transparent layer

In the invention, the transparent layer is a layer which transmits all or part of light emitted from the first organic EL device. The transparent layer preferably has a transmittance of 50% or more in the visible light region.

As the material for the transparent layer, transparent resins (polymers) such as polymethyl methacrylate, polyacrylate, polycarbonate, polyvinyl alcohol, polyvinyl pyrrolidone, hydroxyethylcellulose, and carboxymethylcellulose can be given. It can be used alone or as a mixture of two or more thereof.

As the transparent layer, a color filter material may be used for adjusting color purity, as required. Examples of materials for the color filter include dyes or solid objects in which a dye is dissolved or dispersed in a binder resin. Examples of the dye include copper phthalocyanine dyes, indanthrone dyes, indophenol dyes, cyanine dyes and dioxazin dyes. The dye is possible to use alone or as a mixture of at least two or more kinds. Examples of the binder resin of the dye include transparent resins (polymers) such as polymethyl methacrylate, polyacrylate, polycarbonate, polyvinyl alcohol, polyvinyl pyrrolidone, hydroxyethylcellulose, and carboxymethylcellulose. It can be used alone or as a mixture of two or more thereof. It is preferred to use, as the binder resin, a photosensitive resin to which photolithography can be applied. Examples thereof are photo-setting resist materials having reactive vinyl groups such as acrylic acid type, methacrylic acid type, polyvinyl cinnamate type and cyclic rubber type. The photosensitive resin can be used alone or as a mixture of two or more kinds.

8. Method for producing organic EL device

The suitable method for producing organic EL device is described by way of a configuration example, substrate/first reflective electrode film/optical thickness adjustment layer/hole injecting layer/hole transporting layer/emitting layer/electron injecting layer/second reflective electrode/solid sealing layer/fluorescence conversion film.

First, a fluorescent medium made of a red fluorescent medium, green fluorescent medium and blue color filter is formed on an appropriate transparent substrate. For the method for forming the fluorescent medium, the fluorescent medium is formed by spin coating, printing or some other method. The thickness thereof is usually 500 to 50000 nm and preferably 1000 to 5000 nm.

On the other hand, a first reflective electrode (anode) and light-transmitting layer, which have a desired thickness, are formed by deposition, sputtering or the other method on another appropriate substrate. Thereafter, only a part of the light-transmitting layer corresponding to a pixel which is provided with a fluorescence conversion film is left by etching and the like. Thereafter, thin films made of a hole injecting material, hole transporting material, emitting material and electron injecting material are each formed.

The thin film can be formed by vacuum deposition, spin coating, casting, or some other methods. Vacuum deposition is preferred since a uniform film is easily obtained and pinholes are hardly generated. In the case where the thin film is formed by vacuum deposition, conditions for the deposition vary depending upon the type of a compound to use, the crystal structure or associating structure of an intended molecule-deposited film, and others. In general, the conditions are appropriately selected from the following ranges: boat heating temperatures of 50 to 450°C, vacuum degrees of $10^{-5}$ to $10^{-8}$ Pa, vapor deposition rates of 0.01 to 50 nm/second, substrate temperatures of -50 to 300°C, and film thicknesses of 5 nm to 5 μm. Following the formation of these layers, a second reflective electrode (cathode) is formed thereon in a thickness of usually 10 to 500 nm, preferably 50 to 200 nm by vapor deposition, sputtering or the like.

[Examples]

Example 1

(1) Formation of fluorescence conversion film substrate (method for producing fluorescent medium with RGB pixels)

V259BK (manufactured by Nippon Steel Chemical Co., Ltd.) as the material for a black matrix (BM) was applied by spin coating on a supporting substrate (transparent substrate) (OA2 glass manufactured by Nippon Electric Glass Co., Ltd.) having dimensions of 25 mm x 75 mm x 1.1 mm. Then, ultraviolet rays were applied through a photomask for forming a lattice-shaped pattern. The material was then developed using a 2% sodium carbonate aqueous solution and baked at 200°C to obtain a black matrix pattern (thickness: 1.5 μm).

V259B (manufactured by Nippon Steel Chemical Co., Ltd.) as the material for a blue color filter was applied by spin coating. Then, ultraviolet rays were applied through a photomask aligned with the BM for forming 320 rectangular stripe patterns (90-μm line and 240-μm gap). The material was then developed using a 2% sodium carbonate aqueous solution and baked at 200°C to obtain a blue color filter pattern (thickness: 1.5 μm).

V259G (manufactured by Nippon Steel Chemical Co., Ltd.) as the material for a green color filter was applied by spin coating. Then, ultraviolet rays were applied through a photomask aligned with the BM for forming 320 rectangular

stripe patterns (90-μm line and 240-μm gap). The material was then developed using a 2% sodium carbonate aqueous solution and baked at 200°C to obtain a green color filter pattern (thickness: 1.5 μm) adjacent to the blue color filter.

V259R (manufactured by Nippon Steel Chemical Co., Ltd.) as the material for a red color filter was applied by spin coating. Then, ultraviolet rays were applied through a photomask aligned with the BM for forming 320 rectangular stripe patterns (90-μm line and 240-μm gap). The material was then developed using a 2% sodium carbonate aqueous solution and baked at 200°C to obtain a red color filter pattern (thickness: 1.5 μm) between the blue color filter and the green color filter.

As the material for a green fluorescent medium, ink was prepared by dissolving coumarin 6 in an acrylic negative-tone photoresist ("V259PA" manufactured by Nippon Steel Chemical Co., Ltd., solid content: 50%) in an amount of 0.04 mol/kg (solid content).

The ink was applied on the substrate by spin coating, and ultraviolet rays were applied to the ink above the green color filter. The ink was then developed using a 2% sodium carbonate aqueous solution and baked at 200°C to form a green conversion film pattern (thickness: 10 μm) on the green color filter.

As the material for a red fluorescent medium, ink was prepared by dissolving 0.53 g of coumarin 6, 1.5 g of basic violet 11, and 1.5 g of rhodamine 6G in 100 g of an acrylic negative-tone photoresist ("V259PA" manufactured by Nippon Steel Chemical Co., Ltd., solid content: 50%).

The ink was applied on the substrate by spin coating, and ultraviolet rays were applied to the ink above the red color filter. The ink was then developed using a 2% sodium carbonate aqueous solution and baked at 180°C to form a red conversion film pattern (thickness: 10 μm) on the red color filter. A color conversion substrate was thus obtained.

An acrylic thermosetting resin ("V259PH" manufactured by Nippon Steel Chemical Co., Ltd.) was applied on the substrate by spin coating and then baked at 180°C to form a planarizing film (thickness: 12 μm). A sealing member wherein the fluorescent medium was formed was thus obtained.

(2) Fabrication of organic EL device

A glass substrate, 25 mm x 75 mm x 1.1 mm thick (Corning 7059) was subjected to cleaning in isopropyl alcohol and UV cleaning. The cleaned glass substrate was fixed on a substrate holder in a vacuum deposition device (manufactured by ULVAC, Inc.).

A chrome (Cr) film was formed in a thickness of about 200 nm by sputtering on the grass substrate. The sputtering was performed under the conditions where argon (Ar) was used as the sputtering gas, the pressure in the film-forming atmosphere was kept 0.2 Pa, and the DC output was 300 W. This Cr film functioned as a reflective electrode.

Then, an IZO film was formed in a thickness of 50 nm by sputtering. Thereafter, only an IZO film corresponding to a pixel which was provided with a fluorescence conversion film was left by etching. This IZO film functioned as a light-transmitting layer.

The substrate was transferred to a vacuum deposition device. Indivisual molybdenum heating boats were charged in advance with N,N'-bis(N,N'-diphenyl-4-aminophenyl)-N,N-diphenyl-4,4'-diamino-1,1'-biphenyl (TPD232) as a hole injecting material, 4,4'-bis(N-(1-naphthyl)-N-phenylamino)biphenyl (NPD) as a hole transporting material, DPVDPAN of a styryl derivative and B1 represented by the formula (1) as an organic emitting material, and tris(8-quinolinol) aluminum (Alq) as an electron injecting material. Then, the pressure inside the deposition device was reduced to a vacuum degree of $655 \times 10^{-7}$ Pa. The layers from the electron injecting layer to the hole injecting layer were stacked without breaking the vacuum while adjusting the thickness of each layer such that m of the formula (1) corresponding to a pixel which was provided with a fluorescence conversion film was 2 and m of the formula (1) corresponding to a pixel which was not provided with a fluorescence conversion film was 1.

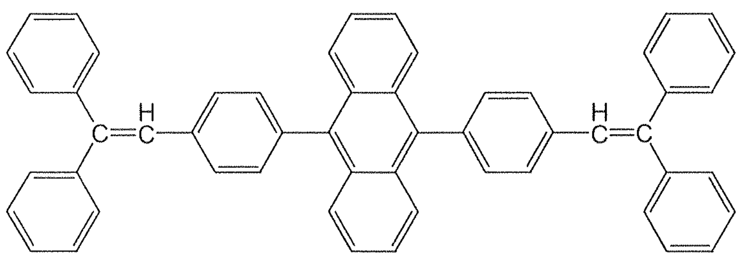

DPVDPAN

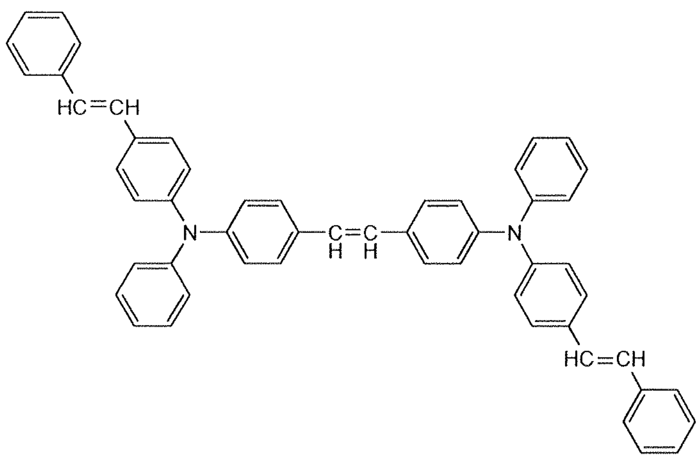

B1

An alloy layer of magnesium (Mg) and silver (Ag) was formed in a thickness of 10 nm at a deposition rate ratio of Mg:Ag = 9:1.
This Mg:Ag film functioned as a reflective electrode.
Then, the substrate was transferred to the sputtering device, and IZO was deposited to a thickness of 500 nm by sputtering. The IZO film functioned as an upper electrode.

In a dry box to which dry nitrogen was introduced, a sealing medium was formed by laminating an O-PET resin which is a polyester resin having a fluoranthene skeleton on the upper electrode to fabricate an organic EL device.

(3) Fabrication of organic EL display

The fluorescence conversion film substrate produced in (1) was placed on the sealing medium of the organic EL device produced in (2). A cation curable type adhesive TB3102 (manufactured by Three Bond) was applied in the periphery of the fluorescence conversion film substrate and then photo-cured to produce an organic EL display.

(4) Evaluation of organic EL display

A DC voltage of 12 V was applied between the above-mentioned electrode and the Cr reflective electrode of the organic EL device fabricated in (2) through an active matrix circuit. The luminance intensity from the front emitting surface was measured for the pixel provided with the fluorescence conversion film and the pixel which was not provided with the fluorescence conversion film using a spectroradiometer SR-3 (field of view: 0.1°) manufactured by Topcon Corporation. The spectroradiometer was inclined with respect to the front surface of the substrate, and an angle at which the value half the luminance intensity from the front surface was obtained was measured. The angle was 32° in the pixel provided with the fluorescence conversion film, and was 51° in the pixel which was not provided with the fluorescence conversion film. Specifically, light from the pixel which was not provided with the fluorescence conversion film had a wide angular intensity distribution, and light from the pixel which was not provided with the fluorescence conversion film had a narrow angular intensity distribution.

When applying a DC voltage of 12 V between the upper electrode and the Cr reflective electrode of the organic EL device fabricated in (3) through an active matrix circuit, the organic EL device emitted white light. The luminance intensity from the front emitting surface was measured using the spectroradiometer. The luminous efficiency was 12 cd/A. White light was also observed when viewed from the direction oblique to the organic EL display.

Comparative Example 1

An organic EL device and an organic EL display were obtained and evaluated in the same manner as in Example 1 except that the thickness of each layer was adjusted so that the organic EL device had a value of 1 for m of the expression (1) in the pixel provided with the fluorescence conversion film and the pixel which was not provided with the fluorescence conversion film.
Light from the pixel provided with the fluorescence conversion film had an angular intensity distribution of 52°, and light from the pixel which was not provided with the fluorescence conversion film also had an angular intensity distribution of 52°. The organic EL display emitted white light and exhibited a luminous efficiency of 9 cd/A, which is lower than that of Example 1.

Comparative Example 2

An organic EL device and an organic EL display were obtained and evaluated in the same manner as in Example 1 except that the thickness of each layer was adjusted so that the organic EL device had a value of 2 for m of the expression (1) in the pixel provided with the fluorescence conversion film and the pixel which was not provided with the fluorescence conversion film.
Light from the pixel provided with the fluorescence conversion film had an angular intensity distribution of 32°, and light from the pixel which was not provided with the fluorescence conversion film also had an angular intensity distribution of 32°. The organic EL display emitted white light and exhibited a luminous efficiency of 12 cd/A. White light was observed from the front side of the organic EL display. However, yellowish light was observed when viewed from the direction oblique to the organic EL display. This is because the blue pixel had a narrow viewing angle since light from the pixel which was not provided with the fluorescence conversion film had a narrow angular intensity distribution.
Table 1

| | m of pixel with fluorescence conversion film | m of pixel without fluorescence conversion film | Luminous efficiency or white light (cd/A) | Veiwing angle at which half of luminance intensity measured from front surface of substrate could be obtained (°) | |
|---|---|---|---|---|---|
| | | | | Pixel with fluorescence conversion film | Pixel without fluorescence conversion film |
| Example 1 | 2 | 1 | 12 | 32 | 51 |
| Comprative Example 1 | 1 | 1 | 9 | 52 | 52 |
| Comprative Example 2 | 2 | 2 | 12 | 32 | 32 |

Industrial Utility

The organic EL device and the display according to the invention can be used as commercial and industrial displays for portable telephones, PDAs, car navigation systems, monitors, TVs, and the like.

## Claims

**1.** An organic electroluminescent display comprising:

a first organic electroluminescent device comprising a first reflective electrode, a second reflective electrode and an organic layer provided therebetween,
a second organic electroluminescent device comprising a first reflective electrode, a second reflective electrode, a light-transmitting layer and an organic layer, the light-transmitting layer and the organic layer being provided between the first and second reflective electrodes, and
a fluorescence conversion film converting the color of light emitted from the second organic electroluminescent device;
the angular distribution of the luminance intensity of light from the second organic electroluminescent device being smaller than the angular distribution of the luminance intensity of light from the first electroluminescent device.

**2.** An organic electroluminescent display comprising:

a first organic electroluminescent device comprising a first reflective electrode, a second reflective electrode, a first light-transmitting layer and an organic layer, the first light-transmitting layer and the organic layer being provided between the first and second reflective electrodes,
a second organic electroluminescent device comprising a first reflective electrode, a second reflective electrode,

a second light-transmitting layer and an organic layer, the second light-transmitting layer and the organic layer being provided between the first and second reflective electrodes, and
a fluorescence conversion film converting the color of light emitted from the second organic electroluminescent device;
the angular distribution of the luminance intensity of light from the second organic electroluminescent device being smaller than the angular distribution of the luminance intensity of light from the first electroluminescent device.

**3.** An organic electroluminescent display comprising:

a first organic electroluminescent device comprising a first reflective electrode, a second reflective electrode and an organic layer provided therebetween,
a second organic electroluminescent device comprising a first reflective electrode, a second reflective electrode, a first light-transmitting layer and an organic layer, the first light-transmitting layer and the organic layer being provided between the first and second reflective electrodes,
a third organic electroluminescent device comprising a first reflective electrode, a second reflective electrode, a second light-transmitting layer and an organic layer, the second light-transmitting layer and the organic layer being provided between the first and second reflective electrodes,
a first fluorescence conversion film converting the color of light emitted from the second organic electroluminescent device, and
a second fluorescence conversion film converting the color of light emitted from the third organic electroluminescent device;
the angular distribution of the luminance intensity of light from the second organic electroluminescent device being smaller than the angular distribution of the luminance intensity of light from the first electroluminescent device, and
the angular distribution of the luminance intensity of light from the third organic electroluminescent device being smaller than the angular distribution of the luminance intensity of light from the first electroluminescent device.

**4.** The organic electroluminescent display according to claim 2 or 3 wherein the second light-transmitting layer comprises the first light-transmitting layer in part.

**5.** The organic electroluminescent display according to any one of claims 1 to 3 further comprising a solid sealing layer sealing an organic electroluminescent device.

**6.** The organic electroluminescent display according to claim 5 wherein the solid sealing layer is provided between the second reflective layer and the fluorescence conversion film.

**7.** The organic electroluminescent display according to any one of claims 1 to 3 wherein at least one of the first and second light-transmitting layers is a transparent conductive layer or transparent semiconductive layer.

**8.** The organic electroluminescent display according to any one of claims 1 to 3 wherein one reflective electrode through which light is outcoupled of the first and second reflective electrodes has a reflectance of 25 or more and less than 50%, and the other reflective electrode has a reflectance of 50% or more.

**9.** The organic electroluminescent display according to any one of claims 1 to 3 wherein at least one of the first and second light-transmitting layers is stacked layers of a dielectric and a transparent electrode.

**10.** The organic electroluminescent display according to any one of claims 1 to 3 wherein at least one of the first and second light-transmitting layers is stacked layers of a metal film and a transparent electrode.

**11.** The organic electroluminescent display according to any one of claims 1 to 3 wherein at least one of the first and second light-transmitting layers comprises a dielectric multilayered film.

**12.** The organic electroluminescent display according to claim 3 wherein the first fluorescence conversion film and the second fluorescence conversion film convert light emitted from the organic layers into light of different colors.

**13.** The organic electroluminescent display according to claim 12 wherein one of the maximum values of an emission spectrum of light from the first organic electroluminescent device is in a blue region,

at least one of the maximum values of an emission spectrum of light from the first fluorescence conversion film which is converted light of the second organic electroluminescent device is in a green region, and
at least one of the maximum values of an emission spectrum of light from the second fluorescence conversion film which is converted light of the third organic electroluminescent device is in a red region.

FIG.1

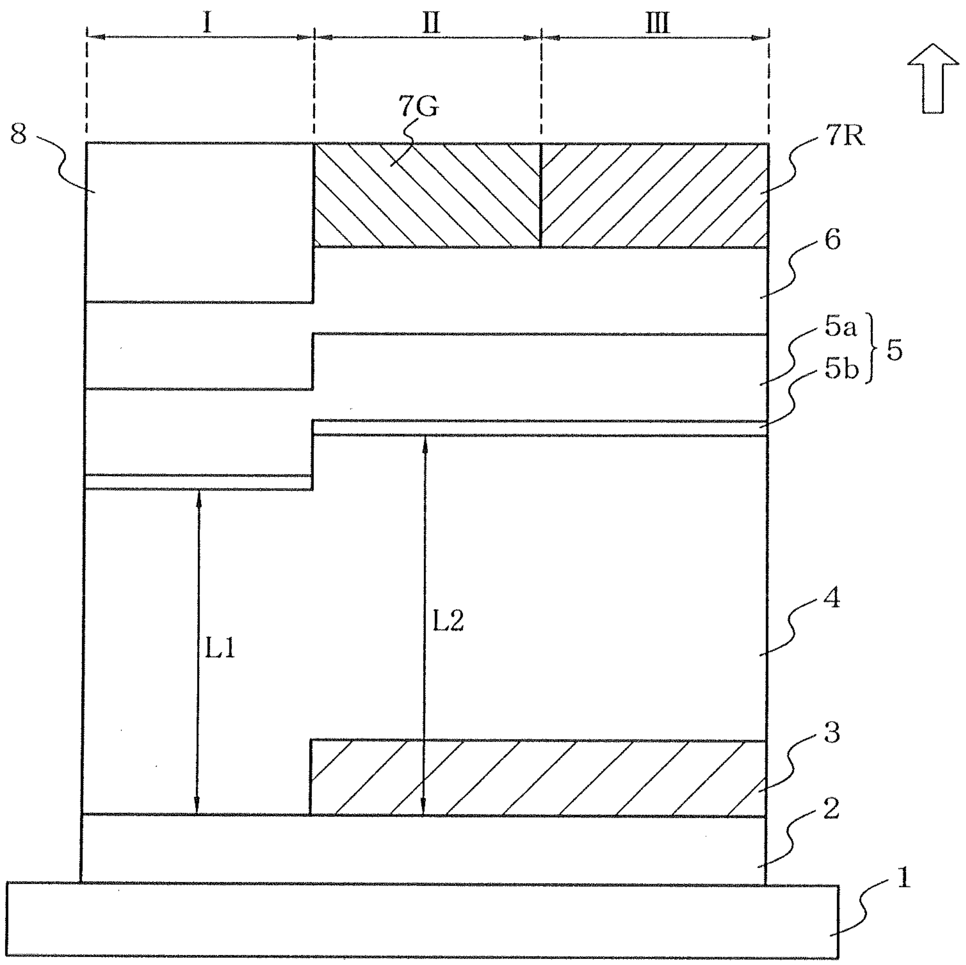

FIG.2

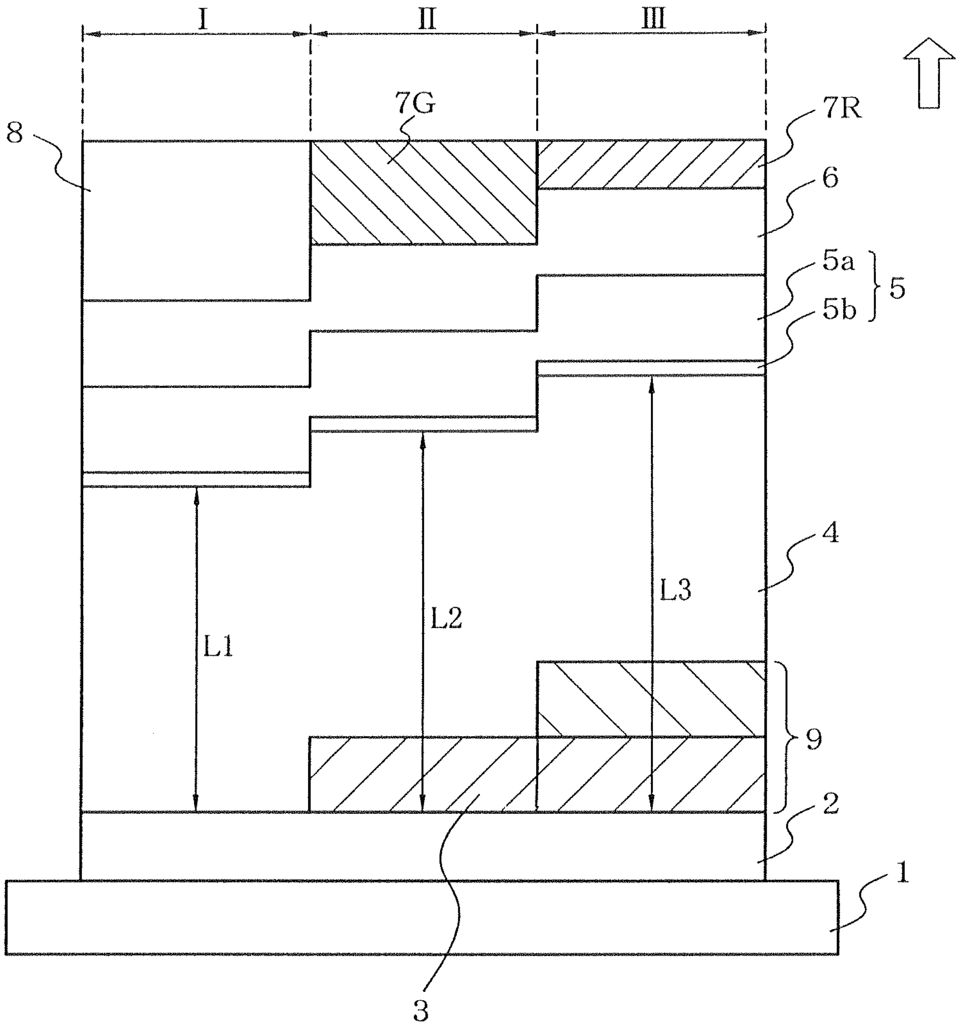

FIG.3

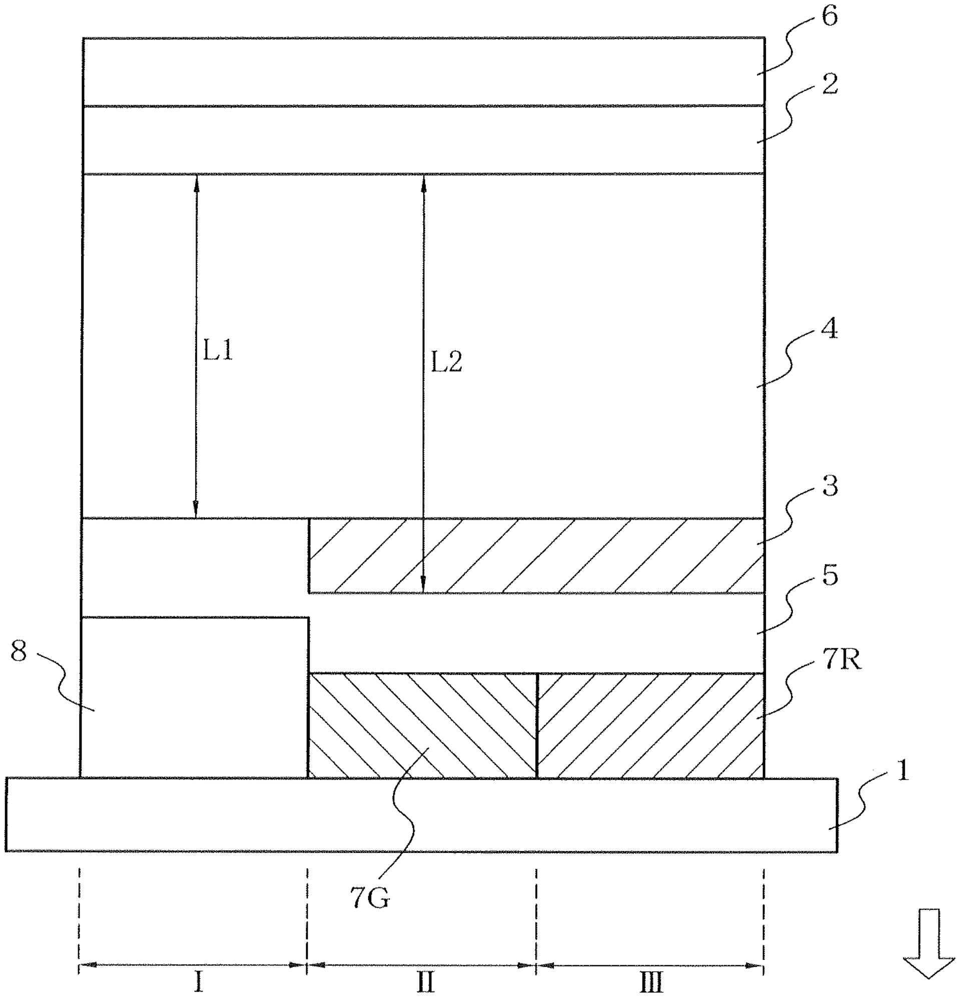

FIG.4

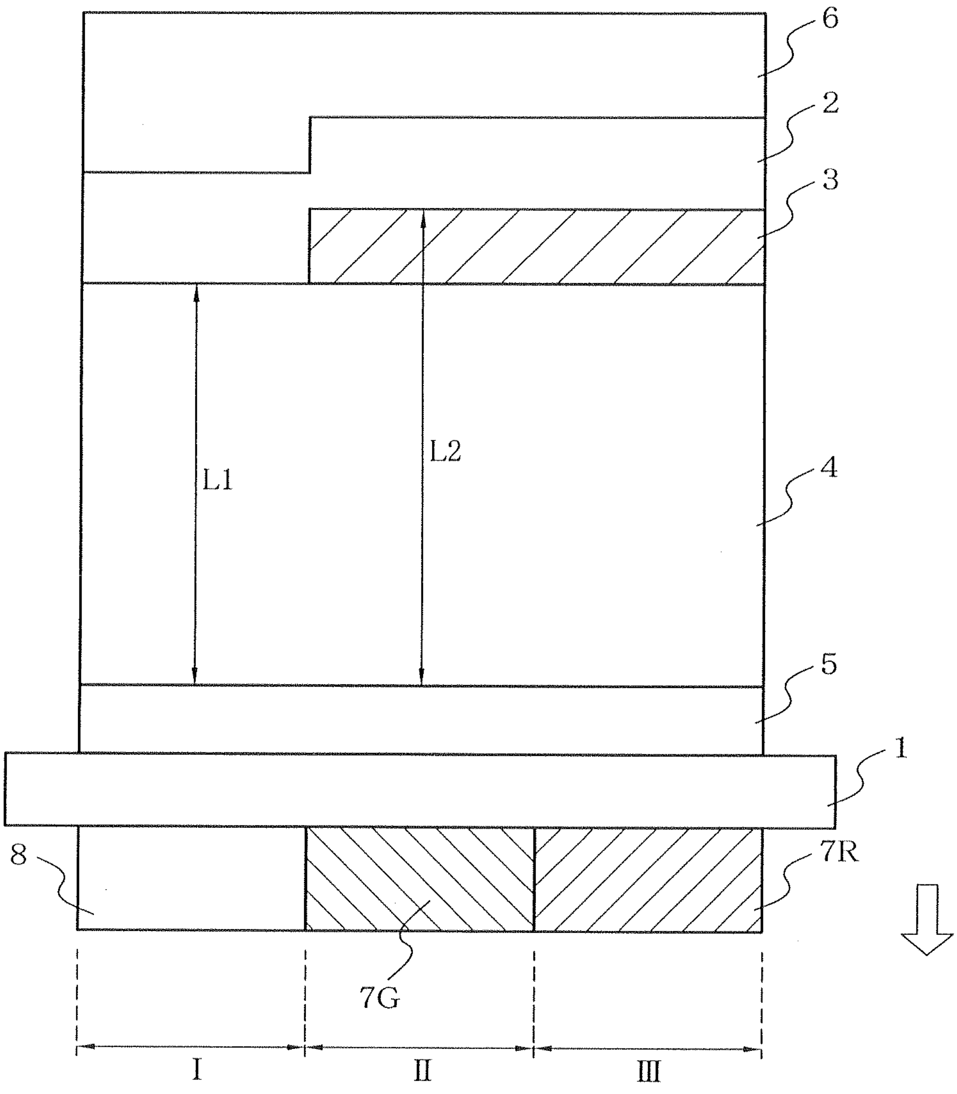

## INTERNATIONAL SEARCH REPORT

International application No.
PCT/JP2005/005946

A. CLASSIFICATION OF SUBJECT MATTER
Int.Cl[7] H05B33/12, 33/14, 33/22, 33/24

According to International Patent Classification (IPC) or to both national classification and IPC

B. FIELDS SEARCHED

Minimum documentation searched (classification system followed by classification symbols)
Int.Cl[7] H05B33/12, 33/14, 33/22, 33/24

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2002-359076 A (Konica Corp.), 13 December, 2002 (13.12.02), Par. No. [0054]; Fig. 4(a); Par. No. [0128] (Family: none) | 1-13 |
| A | JP 2000-68069 A (Idemitsu Kosan Co., Ltd.), 03 March, 2000 (03.03.00), Full text; all drawings (Family: none) | 1-13 |
| P,A | JP 2005-79014 A (Toyota Industries Corp.), 24 March, 2005 (24.03.05), Claim 2; Par. No. [0007] (Family: none) | 1-13 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>15 August, 2005 (15.08.05) | Date of mailing of the international search report<br>06 September, 2005 (06.09.05) |
| Name and mailing address of the ISA/<br>Japanese Patent Office<br>Facsimile No. | Authorized officer<br><br>Telephone No. |

Form PCT/ISA/210 (second sheet) (January 2004)

INTERNATIONAL SEARCH REPORT

International application No.
PCT/JP2005/005946

C (Continuation). DOCUMENTS CONSIDERED TO BE RELEVANT

| Category* | Citation of document, with indication, where appropriate, of the relevant passages | Relevant to claim No. |
|---|---|---|
| A | JP 06-283271 A (Ricoh Co., Ltd.), 07 October, 1994 (07.10.94), Par. Nos. [0009] to [0012], [0031] (Family: none) | 1-13 |
| P,A | JP 2005-116516 A (Sony Corp.), 28 April, 2005 (28.04.05), Example 5; Par. No. [0071] (Family: none) | 1-13 |
| P,A | JP 2005-129510 A (Sanyo Electric Co., Ltd.), 19 May, 2005 (19.05.05), Figs. 3, 5; Par. Nos. [0043], [0049] (Family: none) | 1-13 |
| A | JP 2003-234186 A (Sony Corp.), 22 August, 2003 (22.08.03), Claim 7; Par. No. [0061]; Figs. 1, 3 (Family: none) | 1-13 |
| A | JP 2002-359076 A (Konica Corp.), 13 December, 2002 (13.12.02), Claims 2 to 3; Fig. 4(a) (Family: none) | 1-13 |

Form PCT/ISA/210 (continuation of second sheet) (January 2004)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 0139554 A
- JP 9092466 A